# EUROPÄISCHE PATENTSCHRIFT

(11) **EP 3 062 059 B1**
(45) Veröffentlichungstag und Bekanntmachung des Hinweises auf die Patenterteilung: **23.09.2020**
(21) Anmeldenummer: 16000133.5
(22) Anmeldetag: 21.01.2016
(51) Int. Cl.: F41G 7/00

(54) **STATIONÄRES UND MOBILES TESTGERÄT FÜR FLUGKÖRPER**
STATIONARY AND MOBILE TESTING DEVICE FOR MISSILE
APPAREIL D'ESSAI MOBILE ET FIXE POUR AERONEFS

(30) Priorität: 27.02.2015 DE 102015002587
(43) Veröffentlichungstag der Anmeldung: 31.08.2016
(73) Patentinhaber: MBDA Deutschland GmbH, 86529 Schrobenhausen (DE)
(72) Erfinder: Limmer, Michael, D-86508 Rehling (DE); Gallhauser, Thomas, D-85276 Pfaffenhofen (DE); Surauer, Michael Alois, D-83339 Chieming (DE); Surauer, Christian, D-83339 Chieming (DE); Geidek, Franz, D- 86561 Aresing (DE)
(74) Vertreter: Isarpatent

(56) Entgegenhaltungen:
- DE-A1- 3 238 897
- US-A- 4 860 016
- US-A1- 2011 301 784
- GAO WEI ET AL: "Study on electro-optical jamming effect on TV seekers by flight test", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, Bd. 9233, 14. Juli 2014 (2014-07-14), Seiten 923309-923309, XP060040199, DOI: 10.1117/12.2067752 ISBN: 978-1-62841-730-2
- SANDERS J S; ROLAND R; COSBY D S; SAYLOR D A; HARRISON K R: "Captive flight test-based infrared validation of a hardware-in-the-loop simulation", PROCEEDINGS OF THE SPIE - THE INTERNATIONAL SOCIETY FOR OPTICAL ENGINEERING, Bd. 4027, 26. April 2000 (2000-04-26), - 26. April 2000 (2000-04-26), Seiten 292-300, XP002759044, Orlando, FL, USA ISSN: 0277-786X
- SMITH B J ET AL: "Precision dynamic SAR testbed for tactical missiles", AEROSPACE CONFERENCE, 2004. PROCEEDINGS. 2004 IEEE, IEEE, PISCATAWAY, NJ, USA, Bd. 4, 6. März 2004 (2004-03-06), Seiten 2220-2226, XP010748343, DOI: 10.1109/AERO.2004.1368015 ISBN: 978-0-7803-8155-1

## Beschreibung

Die vorliegende Erfindung betrifft ein Testsystem für einen Flugkörper. Insbesondere betrifft die Erfindung ein stationäres Testgerät sowie ein mobiles Testgerät für einen Flugkörper.

Zum Beschreiben der Erfindung werden die folgenden Abkürzungen verwendet:

| | | |
|---|---|---|
| GNC: | Guidance, Navigation and Control | Lenkung, Navigation und Regelung |
| NGC: | Navigation, Guidance and Control | Navigation, Lenkung und Regelung |
| IMU: | Inertial Measurement Unit | Inertialsensorik System |
| GPS: | Global Positioning System | System zur Postionsbestimmung |
| CAS: | Control Actuator System | Ruderstellsystem eines Flugkörpers |
| LOS: | Line of Sight | Sichtlinie / Blickachse (zw. Flugkörper und Ziel) |
| VTOL: | vertical take off and landing | Fähigkeit eines Luftfahrzeugs, senkrechte Starts und Landungen auszuführen |
| OLED: | organic light emitting diode | organische Leuchtdiode |
| DoF: | Degree of fredom | Anzahl an Freiheitsgraden |

Aus dem Stand der Technik ist bekannt, dass zur Entwicklung von Flugkörpern des Öfteren Flugversuche durchgeführt werden müssen. Dabei stellen derartige Flugversuche einen Kostentreiber bei der Entwicklung von Flugkörpern dar, die es, insbesondere zur Steigerung der Wettbewerbsfähigkeit, zu senken gilt. Flugversuche sind aufgrund eines hohen Personaleinsatzes, sowie des benötigten Einsatzes von Equipment, Infrastruktur und Sicherheitsaspekten, mit einem hohen finanziellen Aufwand verbunden. Besonders in der Anfangsphase eines Projekts der Flugkörperentwicklung haben die Flugversuche teilweise konträr zueinander liegende Absichten. Dies bedingt sich durch die unterschiedlichen Anforderungen der verschiedenen Disziplinen, die an einer Flugkörperentwicklung beteiligt sind. So ist es beispielsweise für den GNC-Entwickler wichtig, so weit wie möglich fliegen zu können, um möglichst lange die GNC-Funktionalität testen können. Dahingegen ist es ein Anliegen der Bildverarbeitungs-Entwicklung, so realistisch wie möglich auf ein reales Ziel zufliegen zu können, um Bilddaten für den entsprechenden Algorithmus zu erhalten. Meistens sind Flugversuche von ihrer Zeitdauer viel zu kurz, um alle Tests durchführen zu können. Erfahrungsgemäß treten auch öfters Fehlfunktionen auf, so dass Flugversuche ihren Nachweis nicht erbringen können und daher wiederholt werden müssen. Aus diesen Gründen sind Bestrebungen erkennbar, Flugversuche zu vermeiden und stattdessen durch Labortests zu ersetzen.

Bei klassischen "Hardware in the Loop"-Testsystemen, die sich in einem Labor befinden, werden rotatorische Freiheitsgrade des Flugkörpers mit einem Drehtisch oder einem Roboter nachgebildet. Unter "Freiheitsgrad" wird dabei die Zahl der voneinander unabhängigen Bewegungsmöglichkeiten des Flugkörpers bezeichnet. Somit weist der Flugkörper sechs Freiheitsgrade auf, da dieser in drei voneinander unabhängige Raumrichtungen bewegbar und um drei voneinander unabhängige Achsen rotierbar ist.

Durch den feststehenden Aufbau in einem Labor besteht jedoch der Nachteil, dass die translatorischen Freiheitsgrade und alle damit zusammenhängenden Funktionen nicht unter realistischen Bedingungen getestet werden können. Die Relativgeometrie zwischen dem Flugkörper und einem anzufliegenden Ziel muss künstlich erzeugt werden, was im Stand der Technik beispielsweise durch simulativ berechnete Werte des Flugkörpers geschieht. Diese Werte werden dann in die Flugkörper-Avionik anstelle der wirklichen Werte künstlich eingespeist. Dazu ist wichtig, das Verhalten der relevanten Systeme, wie IMU, Suchkopf, GPS, usw., während des Fluges zu kennen.

In der Praxis hat sich gezeigt, dass dieses Verhalten im realen Flug oftmals wesentlich unterschiedlich zu dem Verhalten ist, das im Labor beobachtbar ist. Ebenso können für optische Suchköpfe, die für die gesamte Kette der Sichtlinienrekonstruktion und Sichtlinienlenkung wichtigen geometrischen Verhältnisse wie Aspektwinkel, Aspektratio, Annäherung, Bildexplosion oder Umweltstörungen, nur unzureichend und künstlich nachgestellt werden. Möchte man realistische Daten, z.B. von einem Suchkopf, so gibt es die Möglichkeit, auf manntragenden Fluggeräten, wie Flugzeug oder Hubschrauber, Tragflüge durchzuführen. Diese Tragflüge sind sehr kostenintensiv und oft teurer als reale Flugversuche, bedingt durch den hohen Einsatz an Ressourcen und Sicherheitsaspekten. Aus kinematischen Gründen können oft keine realen translatorischen Flugbahnen durch Tragflüge erzielt werden, besonders bei Boden-Boden-Flugkörpern.

Weiterhin ist aus dem Stand der Technik bekannt, unbemannte Flugkörper als Testobjekte für eine Navigationssoftware zu verwenden. Dazu weist der Flugkörper ein festes Navigationssystem auf, wobei bei einem standardisierten Flug ein Ansprechen der Navigationssoftware überprüft werden kann. Ein derartiger Flugkörper ist insbesondere aus der DE 10 2011 115 963 B3 bekannt.

Das Dokument "Study on electro-optical jamming effect on TV seekers by flight test" von Gao Wei et al., Optomechatronic Micro/Nano Devices and Components III: 8-10 Oktober 2007, Lausanne, Switzerland, Bd. 9233, 14. Juli 2014, Seiten 923309-923309, beschreibt ein Testschema für ein unbemanntes Flugzeug, wobei ein optischer Sucher an einer Trägerplattform befestigt ist. Das unbemannte Flugzeug fliegt im Wesentlichen entlang einer geraden Linie und die Flugdaten werden während des Fluges aufgezeichnet, wie beispielsweise die Flugkurve, Geschwindigkeit und Höhenwinkel. Das Flugzeug fliegt relativ zu einem vorbestimmten Ziel und versucht, eine Vernebelungswolke zwischen Ziel und dem unbemannten Flugzeug derart zu platzieren, dass es von der Position des Ziels aus verhindert wird, das Flugzeug mittels bestimmter Techniken zu erfassen.

Die Druckschrift US 2011/301784 A1 beschreibt einen Testhubschrauber mit reduzierten Abmessungen, welcher einen Autopiloten, ein GPS-System sowie ein Navigationssystem aufweist.

Das Dokument "Captive flight test-based infrared validation of a hardware-in-theloop simulation" von Sanders; Roland; Crosby; Saylor und Harrison, Proceedings of the SPIE - The International Society for Optical Engineering, Bd. 4027, 26. April 2000, Seiten 292-300, beschreibt eine Hardware-in-the-Loop(HWIL)-Simulation, welche auf Daten basiert, die mittels eines Infrarotsuchers gesammelt werden.

Die Druckschrift "Precision dynamic SAR testbed for tactical missiles", von Smith, Aerospace Conference, 2004, Proceedings. 2004, Bd. 4, 6. März 2004, Seiten 2220-2226, beschreibt eine stationäre Prüfanordnung, welche mittels eines Schienensystems zwei translatorische Bewegungen simulieren kann.

Es ist Aufgabe der Erfindung, ein stationäres Testgerät sowie ein mobiles Testgerät für einen Flugkörper anzugeben, die bei einfacher und kostengünstiger Herstellung eine sichere und zuverlässige, und dabei kostengünstige, Durchführung von Tests des Flugkörpers erlauben. Schließlich ist es Aufgabe der Erfindung, ein Testsystem aus den zuvor genannten Testgeräten anzugeben.

Gelöst wird die Aufgabe durch die Merkmale der unabhängigen Ansprüche.

Die Aufgabe wird gelöst durch ein Testsystem mit den Merkmalen des Anspruchs 1. Die Flugplattform ist insbesondere eine unbemannte, besonders vorteilhaft nicht-manntragende, Flugplattform. Die Trägervorrichtung ist an der Flugplattform befestigt und dient zur Aufnahme eines Avionik-Prüflings des Flugkörpers. Dabei erlaubt die Trägervorrichtung ein Bewegen des Avionik-Prüflings in drei rotatorischen Freiheitsgraden. Mit der Trägervorrichtung ist bevorzugt die Sichtlinie für den Avionik-Prüfling und die Relativ-Geometrie zwischen dem Schwerpunkt des Flugkörpers und dem Schwerpunkt des anzufliegenden Ziels erzeugbar. Das Steuermodul erlaubt die Ansteuerung der Flugplattform zum Abfliegen einer vorbestimmten Referenz-Trajektorie. Außerdem erlaubt das Steuermodul, die Trägervorrichtung zum Ausrichten des Avionik-Prüflings anzusteuern. Schließlich sind mit dem Steuermodul die von dem Avionik-Prüfling erzeugten Navigationsdaten speicherbar. Mit dem mobilen Testgerät ist daher ein Flug des Flugkörpers simulierbar, wobei insbesondere die Fluggeschwindigkeit der Flugplattform nicht der Fluggeschwindigkeit des Flugkörpers entspricht. Somit ist eine Simulation des Fluges nicht in Echtzeit ermöglicht, sondern in einer verlangsamten Geschwindigkeit. Die von dem Steuermodul gespeicherten Navigationsdaten sind besonders vorteilhaft für die Simulation mit dem stationären Testgerät gemäß der Erfindung verwendbar.

Die Unteransprüche haben vorteilhafte Weiterbildungen der Erfindung zum Inhalt.

Besonders vorteilhaft ist die Trägervorrichtung des Testsystems eine Gimbalplattform. Somit ist ein einfaches und performantes Ausrichten des Avionik-Prüflings ermöglicht.

Die Flugplattform ist bevorzugt ein Hubschrauber. Somit ist insbesondere die Fähigkeit für vertikale Starts und Landungen gegeben. Besonders vorteilhaft weist die Flugplattform zumindest zwei horizontal orientierte Rotoren auf. Da für eine derartige Anordnung von Rotoren eine Zustandsregelung notwendig ist, führt das Steuerungsmodul, wie zuvor beschrieben, bevorzugt auch die Ansteuerung an die Flugplattform durch, so dass mit der von dem Steuermodul durchgeführten Zustandsregelung ein stabiler Flug mit der Flugplattform ermöglicht ist.

Die Erfindung betrifft demnach ein Testsystem für einen Flugkörper, wobei das Testsystem ein stationäres Testgerät und ein mobiles Testgerät umfasst. Das stationäre Testgerät umfasst insbesondere eine Haltevorrichtung und eine Anzeigevorrichtung. Die Haltevorrichtung dient insbesondere zur Aufnahme eines Avionik-Prüflings des Flugkörpers, wobei die Haltevorrichtung eine Bewegung des Avionik-Prüflings in drei rotatorische Freiheitsgrade ermöglicht. Die Anzeigevorrichtung dient zum Darstellen von Umfeldinformationen des Flugkörpers. Die Anzeigevorrichtung ist innerhalb einer virtuellen Ebene, insbesondere durch ein translatorisches Schlittensystem, verschiebbar. Somit ist die Anzeigevorrichtung in zwei translatorischen Freiheitsgraden verschiebbar, wodurch zwei translatorische Freiheitsgrade des Flugkörpers simulierbar sind. Insbesondere sind auf diese Weise translatorische Freiheitsgrade des Flugkörpers senkrecht zu einer Längsachse des Flugkörpers, oder Sichtachse des Avionik-Prüflings, simulierbar. Dazu ist vorgesehen, dass die Anzeigevorrichtung von dem Avionik-Prüfling erfassbar ist, wenn der Avionik-Prüfling auf der Haltevorrichtung angeordnet ist. Wird die Anzeigevorrichtung, wie zuvor beschrieben, verschoben, so wird dem Suchkopf eine translatorische Bewegung des Flugkörpers suggeriert. Die Anzeigevorrichtung selbst simuliert eine translatorische Bewegung des Flugkörpers in einer dritten Bewegungsrichtung, wobei diese dritte Bewegungsrichtung insbesondere parallel zu einer Längsachse des Flugkörpers, oder zu der Sichtachse des Avionik-Prüflings, ausgerichtet ist. So ist insbesondere ein OLED-Bildschirm als Anzeigevorrichtung vorgesehen, auf dem durch ein Video-System Echzeit-Umfeldinformationen darstellbar sind. Auf diese Weise ist ein Flug des Flugkörpers realitätsgetreu simulierbar, wodurch auch geometrische Verhältnisse wie Aspektwinkel, Aspektratio, Annäherung, Bildexplosion oder Umweltstörungen, wie Änderung der Lichtverhältnisse, realitätsnah simulierbar sind. Die synchron benötigten Daten für den Avionik-Prüfling, wie insbesondere IMU-Daten, werden bevorzugt künstlich in den Avionik-Prüfling eingeschweißt.

Das stationäre Testgerät weist bevorzugt eine Steuereinheit auf. Mit der Steuereinheit ist eine Bewegung der Haltevorrichtung und eine Verschiebung der Anzeigevorrichtung steuerbar. Außerdem ist bevorzugt vorgesehen, dass mit der Steuereinheit das zuvor genannte Videosystem und damit die Anzeige auf der Anzeigevorrichtung steuerbar sind. Auf diese Weise ist insbesondere das Abfliegen einer vordefinierten Referenz-Trajektorie simulierbar, wobei mit der Steuereinheit die von dem Avionik-Prüfling erzeugten Navigationsdaten speicherbar sind. Besonders bevorzugt ist das Verhalten des Flugkörpers während des Abfliegens der Referenz-Trajektorie zuvor mit dem mobilen Testgerät gemäß der Erfindung simuliert worden, so dass mit der Steuereinheit des stationären Testgeräts eine realitätsgetreue Ansteuerung der Bewegung der Haltevorrichtung und der Verschiebung der Anzeigevorrichtung ermöglicht ist.

Schließlich ist bevorzugt vorgesehen, dass die Haltevorrichtung ein Drehtisch oder ein Roboter ist.

Das Testsystem kennzeichnet sich bevorzugt dadurch aus, dass das stationäre Testgerät mit Simulationsdaten betreibbar ist, die aus Messdaten gewinnbar sind. Dabei ist vorgesehen, dass die Messdaten während des Betriebs des mobilen Testgeräts erfassbar sind. Somit ist eine sehr akkurate Simulation mit dem stationären Testgerät ermöglicht.

Besonders vorteilhaft ist vorgesehen, dass die Simulationsdaten, die aus den während des Betriebs des mobilen Testgeräts erhaltenen Messdaten gewinnbar sind, IMU-Daten, GPS-Daten, CAS-Daten und Suchkopf-Daten, umfassen.

Schließlich betrifft die Erfindung ein Verfahren zum Testen von Flugkörpern mit einem Testsystem, wie zuvor beschrieben. Das Verfahren umfasst die folgenden Schritte: Zunächst wird eine Referenz-Trajektorie, insbesondere eine dreidimensionale und/oder translatorische, Referenz-Trajektorie festgelegt. Die Referenz-Trajektorie bildet bevorzugt eine Relativgeometrie zwischen dem Flugkörper und einem Ziel, das der Flugkörper anfliegen soll, nach. Als nächster Schritt erfolgt das Abfliegen der Referenz-Trajektorie mit einem mobilen Testgerät. Dabei ist vorgesehen, dass an dem mobilen Testgerät ein Avionik-Prüfling des Flugkörpers angeordnet ist. Besonders vorteilhaft erfolgt eine Aufzeichnung von Navigationsdaten, die der Avionik-Prüfling während des Abfliegens der Referenz-Trajektorie generiert. In einem letzten Schritt erfolgt eine Simulation einer Bewegung des Flugkörpers mit einem stationären Testgerät. Dazu ist der Avionik-Prüfling an dem stationären Testgerät angeordnet. Die Simulation erfolgt anhand von Simulationsdaten, die auf den während des Abfliegens der Referenz-Trajektorie mit dem mobilen Testgerät erhaltenen Messdaten basiert. Somit ist eine sehr akkurate Simulation des Flugkörpers ermöglicht, wodurch eine Vielzahl von Flugtests vorab durch das stationäre Testgerät simulierbar sind.

Weitere Einzelheiten, Vorteile und Merkmale der vorliegenden Erfindung ergeben sich aus nachfolgender Beschreibung von Ausführungsbeispielen anhand der Zeichnung. Es zeigt:
- Fig. 1: eine schematische Übersicht über einen Entwicklungsprozess einer Flugkörper-Avionik,
- Fig. 2: eine schematische Übersicht über ein Testsystem gemäß einem Ausführungsbeispiel der Erfindung,
- Fig. 3: eine schematische Darstellung eines mobilen Testgeräts gemäß einem Ausführungsbeispiel der Erfindung,
- Fig. 4: eine schematische Darstellung eines stationären Testgeräts gemäß einem Ausführungsbeispiel der Erfindung,

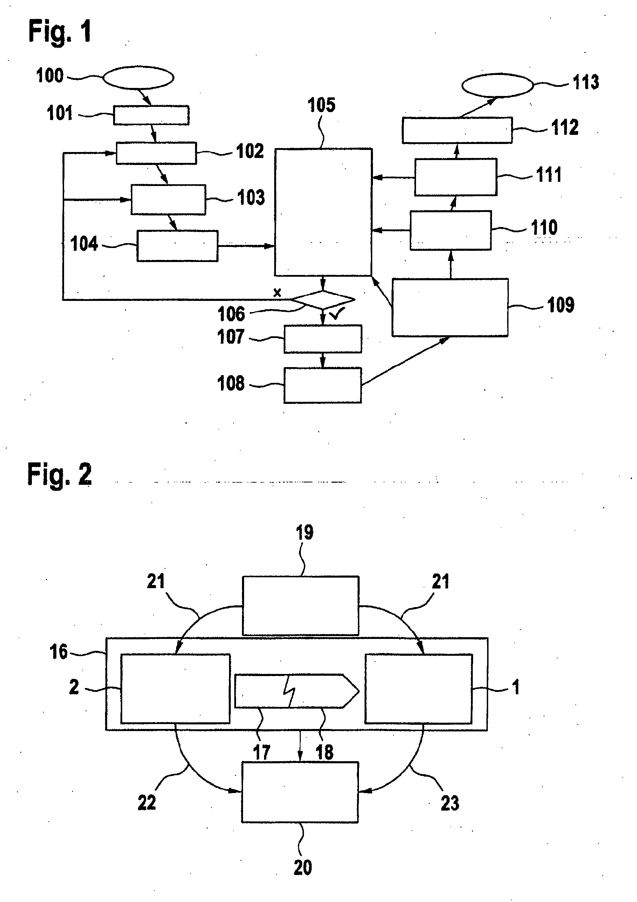

Fig. 1 zeigt schematisch einen Überblick über einen Produktentwicklungsprozess eines Flugkörpers, wobei, ausgehend von einer Idee 100, ein fertiges Produkt 113 erreicht werden soll. Dabei erfolgt in einem ersten Schritt die Festlegung von Anforderungen 101. Anschließend erfolgt die Durchführung des Modelldesigns 102.

Danach wird der NGC-Algorithmus-Entwurf 103 durchgeführt, so dass in einem weiteren Schritt eine Simulationsanalyse 104 durchführbar ist. Anschließend erfolgt als zentrales Element der Validierungsprozess 105. Sollten die Ergebnisse dieses Validierungsprozesses 105 in einer Ergebnisüberprüfung 106 nicht zufriedenstellend sein, so erfolgt ein iterativer Prozess durch Aufrufen der bereits durchgeführten Schritte Modelldesign 102 und NGC-Algorithmus-Entwurf 103 mit anschließender Simulationsanalyse 104, Validierungsprozess 105 und Ergebnisüberprüfung 106. Dies geschieht so lange, bis der Ergebnisüberprüfung 106 zufriedenstellende Ergebnisse vorliegen.

Sobald zufriedenstellende Ergebnisse aus dem Validierungsprozess 105 vorliegen, erfolgt die Validierung des Softwarecodes 107 sowie der Avionik-Entwurf 108. Nach dem Avionik-Entwurf 108 muss eine Avionik-Validierung 109 erfolgen, wobei nach durchgeführter Avionik-Validierung 109 erneut der Validierungsprozess 105 aufgerufen wird.

Gleichzeitig erfolgt nach der Avionik-Validierung 109 eine Verifikation des Gesamtsystems 110, was ebenfalls zu dem Aufrufen des Validierungsprozesses 105 führt. Anschließend erfolgt die Validierung des Gesamtsystems 111, wobei ebenfalls zu dem Validierungsprozess 105 zurückgekehrt werden kann. Es ist somit ersichtlich, dass der gesamte Entwicklungsfortschritt eine Vielzahl von Iterationen enthalten kann, wobei für den Validierungsprozess 105 oftmals eine Vielzahl von Flugversuchen des Flugkörpers durchgeführt werden müssen. Sollte die Validierung des Gesamtsystems 111 erfolgreich verlaufen sein, so erreicht man über die Qualitätskontrolle 112 das fertige Produkt 113.

Die vorliegende Erfindung setzt an dem Schritt der Avionik-Validierung 109 an, um hier die Anzahl an Flugtests zu reduzieren und um eine maximale Anzahl an Tests bereits in einem Labor simulieren zu können. Dabei ist insbesondere vorgesehen, dass Labortests auch zusätzlich zu Flugversuchen durchführbar sind, so dass simulative Ergebnisse durch reale Tests bestätigt werden können.

Fig. 2 zeigt schematisch eine Übersicht über ein Testsystem 16 gemäß einem Ausführungsbeispiel der Erfindung. Das Testsystem 16 wird auch als integrierter 6DoF-Testbench 16 bezeichnet, wobei die Abkürzung DoF Degree of Freedom, bedeutet und angibt, in wie vielen Freiheitsgraden eine Simulation möglich ist.

Aus der Fig. 2 ist außerdem ersichtlich, wie das Testsystem 16 mit einem Generic Avionic Design Tool 19, 20 zusammenwirkt. Unter Generic Avionic Design Tool (GADT) ist ein Überbegriff eines Software- und Hardware-Werkzeugkasten zu verstehen, der für das Rapid-Prototyping und für die Rapid-Qualification von Flugführungssystemen im Flugkörperbereich angelegt wurde. Er umfasst verschiedenste Hardware- und Software-Werkzeuge die alle ineinander greifen. Damit kann man sehr effizient die Avionik und das Equipment eines Flugkörpers testen, graphisch darstellen, auswerten und dokumentieren. Das Generic Avionic Design Tool 19, 20 ist nicht Gegenstand dieser Erfindung.

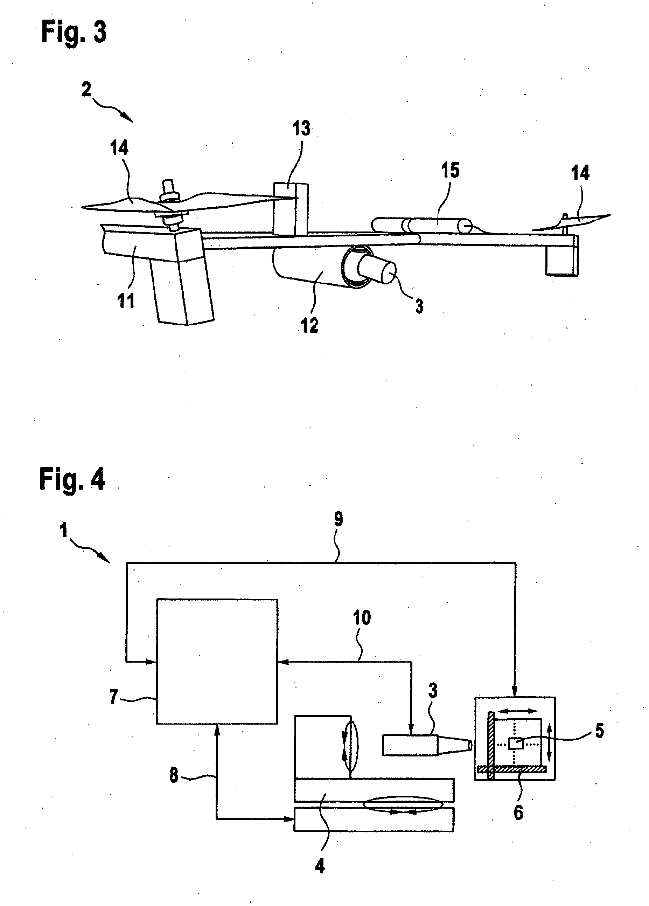

Die Integrierte 6DoF-Testbench 16 ist ein neuer Hardware- und Software-Bestandteil des Werkzeugkasten Generic Avionic Design Tool 19, 20 und ist ein Werkzeug für den zuvor beschriebenen Schritt "Avionik Equipment & NGC Subsystem Validation", d.h. den Schritt der Avionik-Validierung 109. Für diesen Schritt werden aus dem Werkzeugkasten GADT 19, 20 auch die "GADT-Algorithm Design Libary" und die "GADT-Algorithm Design Environment" benutzt, die in Fig. 2 als erstes GADT 19 zusammengefasst sind. Mit diesen beiden Werkzeugen werden für ein relevantes Testszenario durch Simulation die 6Dof Bewegung des Flugkörpers berechnet und diese dann über eine Bodenstation auf eine Flugplattform 11, insbesondere eine VTOL-Plattform, gebracht, die dann die Synchronisation zwischen translatorischer Position und zugehöriger Lage des Avionik-Prüflings 3 übernimmt. Die genaue Funktionsweise wird nachfolgend mit Bezug auf die Fig. 3 und 4 beschrieben.

Ebenso wird aus dem Werkzeugkasten GADT 19, 20 das GADT-Debug & Telemetrie System benutzt um die relevanten Testdaten vom Avionik-Prüfling 3 abzugreifen und zu speichern. Im Validationsprozess wird das GADT-Postflight Simulation & Validation Tool benutzt, das in Fig. 2 als zweites GADT 20 dargestellt ist.

Insgesamt ist es daher nach Berechnung einer Referenz-Trajektorie 21 durch das erste GADT 19 ermöglicht, mit dem Testsystems 16 Flugversuche durchzuführen, die sich in Tragflugversuche mit dem mobilen Testgerät 2 und in Simulationen mit dem stationären Testgerät 1 unterteilen. Die so durch das mobile Testgerät 2 erhaltenen ersten Testdaten 22 und die durch das stationäre Testgerät 1 erhaltenen zweiten Testdaten 23 können daher in dem Validierungsprozess mit dem zweiten GADT 20 verwendet werden.

Der Begriff Validation und Verifikation wird im Zusammenhang mit Flugkörpersystemen oder Subsystemen in folgendem Kontext benutzt:
- Ein verifiziertes reales System/Subsystem ist ein System, bei dem nachgewiesen wurde, dass das System sich bezüglich seiner festgeschriebenen Spezifikation fehlerfrei verhält. (Ist das System richtig gebaut?)
- Ein verifiziertes synthetisches Modell eines Referenz-Systems/Modells, ist ein Modell, das sich auf Signalebene gegenüber dem Referenz-System/Modell fehlerfrei und gleich verhält. (Ist das Modell richtig gebaut? Verhält es sich wie das Referenz-System/Modell? Ob das Referenz-System validiert ist, ist nicht notwendig.)
- Ein validiertes reales System/Subsystem ist ein System, bei dem nachgewiesen wurde, dass das System in seiner wirklichen Einsatzumgebung den festgeschriebenen Anforderungen entspricht. (Funktioniert das System richtig?)
- Ein validiertes synthetisches Modell ist ein Modell, das sich auf Signalebene gegenüber dem validierten realen System ausreichend gleich verhält. (Verifikation des synthetischen Modells ist dabei Grundvorrausetzung.)

Die Integrierte 6DoF-Testbench 16 besteht im wesentlichem aus zwei Teilen, der Mobilen 6DoF Testbench 2 und der Stationären 6DoF Testbench 1.

Mit der Mobilen 6DoF Testbench 2 ist es möglich, ohne den hohen Aufwand von Personal, Auflagen der Sicherheit, Infrastruktur, etc., wiederholt kostengünstige Tragflugversuche in realistischer Umgebung durchzuführen. Dabei werden Messdaten 17 aufgezeichnet, die anschließend im Labor als Simulationsdaten 18 dienen und mit der Stationären 6DoF Testbench 1 beliebig analysiert werden können.

Durch die kostengünstige Wiederholbarkeit der Tragflüge löst es zum einen den eingangs beschriebenen Konflikt der unterschiedlichen Anforderungen und der zeitlichen Begrenzung bei Flugversuchen und liefert Daten für alle Anforderungen. Zum anderen kann mit der integrierten 6DoF-Testbench 16 komplexe NGC-Funktionalität getestet werden, um damit Misserfolge in Flugtests zu reduzieren. Insbesondere ist vorgesehen, dass die integrierte 6DoF-Testbench 16 keine Flugversuche ersetzt, sondern eine Ergänzung zur klassischen Validation durch Flugversuche ist.

### Mobile 6DoF Testbench 2

Zunächst wird die mobile 6DoF Testbench 2 beschrieben. Es soll mit einer Flugplattform 11, insbesondere mit einer VTOL-Trägerplattform, an der ein Avionik-Prüfling 3 angeordnet ist, auf einer mit dem ersten GADT 19 ermittelten und programmierten translatorischen 3DoF Referenz-Trajektorie 21 geflogen werden.

Die Flugplattform 11 umfasst bevorzugt zwei versetzt angeordnete und horizontal orientierte Rotoren 14, sodass eine Eignung zum senkrechten Starten und Landen gegeben ist. Der Avionik-Prüfling 3 ist insbesondere mittig zwischen den beiden Rotoren 14 angeordnet. Die Flugplattform 11 erzeugt für den Avionik-Prüfling die Sichtlinie und die Relativgeometrie zwischen dem Schwerpunkt des zu simulierenden Flugkörpers und dem Schwerpunkt des anzufliegenden Ziels.

Die Referenz-Trajektorie 21 wird mit einer (nicht gezeigten) Boden- und Bedienstation für die Flugplattform 11, insbesondere die VTOL-Trägerplattform, aufbereitet und übertragen. Die 3DoF Referenz-Trajektorie 21 bildet die reale Relativgeometrie zwischen dem Flugkörper und einem anzufliegenden Ziel nach. Die Flugplattform 11, insbesondere die VTOL-Trägerplattform, besitzt eine Trägervorrichtung 12, insbesondere eine 3DoF rotatorische Gimbalplattform, in dem der Avionik-Prüfling 3 in drei Freiheitsgraden rotierbar ist. Damit ist es möglich, die wirkliche Begegnungsgeometrie eines Flugkörpers in sechs Dimensionen in realer Umwelt abzubilden. Auf Grund von Geschwindigkeitsbegrenzungen in der Flugplattform 11, insbesondere der VTOL-Trägerplattform, wird die Referenz-Trajektorie 21 nicht in Echtzeit abgeflogen.

Die Einhaltung der Referenz-Trajektorie 21 und die zeitliche Koordination zwischen Position und zugehöriger Lage des Avionik-Prüflings 3 übernimmt ein Steuermodul 13. Um die realen Testdaten, die im Testflug von dem Avionik-Prüfling 3 auftreten, speichern zu können, weist das Steuermodul 13 ein Data-Logger und ein Messmodul auf. Die gesamte Energie, die zum Antrieb der Rotoren 14 und zum Betrieb des Steuermoduls 13, der Trägervorrichtung 12 und des Avionik-Prüflings 3 benötigt wird, ist von einer Energiemodul 15 bereitgestellt. Das Energiemodul 15 ist, ebenso wie das Steuermodul 13, an der Flugplattform 11 angeordnet. Insbesondere umfasst das Energiemodul 15 einen Akkumulator oder eine Batterie zur Speicherung von elektrischer Energie.

Die nicht gezeigte Boden- und Bedienstation ist die kommunikative Schnittstelle zwischen einem das mobile Testgerät 2 bedienenden Menschen und der Flugplattform 11. Sie hat die Aufgabe über einen Up-Downlink Daten zu der Flugplattform 11 auszutauschen und diese graphisch für den Bediener aufzubereiten. Diese Daten dienen zur Steuerung und Überwachung der Flugplattform 11.

Das Steuermodul 13 bildet die Funktion der Flugzustandsregelung für die Flugplattform 11 ab, um auf einer beliebigen Trajektorie, insbesondere auf der Referenz-Trajektorie 21, zu fliegen. Außerdem steuert das Steuermodul 13 die zeitliche Koordination zwischen Position und Lage des Avionik-Prüflings 3. Die Lage wird dann als Kommando an die Trägervorrichtung 12 gesendet und, insbesondere als Gimbalwinkel, umgesetzt. Der Data-Logger und das Messmodul nehmen als Realtime-Messsystem alle relevanten Messdaten des Avionik-Prüflings 3 in Echtzeit auf und speichern diese ab. Auf diese Weise werden die zuvor genannten Messdaten 17 erhalten.

Die Trägervorrichtung 12, insbesondere die 3D rotatorische Gimbalplattform, bildet sowohl die mechanische als auch die elektrische Schnittstelle zwischen Avionik-Prüfling 3 und Flugplattform 11. Die Trägervorrichtung 12 hat die Aufgabe, die Lage des Avionik-Prüflings 3, die bei einem echten Anflug des zu simulierenden Flugkörpers auftreten würde, nachzubilden. Die Lage des Avionik-Prüflings 3 wird im Vorfeld für den jeweiligen Testfall vom ersten GADT 19 berechnet und über die Boden- und Bedienstation auf das Steuermodul 13 aufgebracht. Die zeitliche Koordination und Ansteuerung der Trägervorrichtung 12, insbesondere der rotatorischen Gimbalplattform, übernimmt das Steuermodul 13.

Die Mobile 6DoF Testbench 2 hat folgende Hauptaufgaben:
- Qualifikation/Validation von Bildverarbeitung & NGC-Subfunktionen, insbesondere von_Suchkopf & IP & Bildverarbeitung, des Navigationssystem und von Guidance & Control
- Equipment-Datenakquisition für Weiterverarbeitung in der Stationären 3Dof-Testbench 1 und anschließender Validation, insbesondere die Suchkopf-Daten Aufzeichnung eines echten Anfluges (Video, IP, SAL) zur Unterstützung der Algorithmen-Entwicklung (FoV Problematik, Timing, Bildverarbeitung, ...), die IMU-Daten Aufzeichnung, und die GPS-Daten Aufzeichnung

### Stationäre 6DoF Testbench 1

Fig. 4 zeigt schematisch das stationäre Testgerät 1 gemäß einem Ausführungsbeispiel der Erfindung, wobei das stationäre Testgerät 1 auch stationäre 6DoF Testbench 1 genannt wird.

Mit der stationären 6DoF Testbench 1 werden die drei rotatorischen Freiheitsgrade des Flugkörpers mit einer Haltevorrichtung 4, insbesondere mit einem 3DoF Drehtisch, in der Realität nachgebildet. Die zwei translatorischen Freiheitsgrade quer zur Sichtlinie, insbesondere quer zu einer Längsachse des Flugkörpers, werden durch ein 2Dof translatorisches Schlittensystem 6 in der Realität abgebildet.

Der letzte translatorische Freiheitsgrad, die Annäherung auf der Sichtlinie, insbesondere der Längsachse des Flugkörpers, und die damit veränderlichen geometrischen Verhältnisse wie Aspektwinkel, Aspektratio, Annäherung, Bildexplosion, oder Umweltstörungen wie Hintergrund, Lichtverhältnisse, etc. werden durch ein Video-System auf einer Anzeigevorrichtung 5, insbesondere auf einem OLED-Bildschirm, in Echtzeit dargestellt. Die dazu synchron benötigten Daten für den Avionik-Prüfling 3, wie insbesondere die IMU-Daten, werden künstlich in den Avionik-Prüfling 3 eingespeist. Realistische Simulationsdaten 18 werden aus den Messdaten 17 gewonnen, die zuvor durch die Mobile 6Dof-Testbench 2 aquiriert wurden. Alle relevanten Daten, insbesondere Navigationsdaten, aus dem Avionik-Prüfling 3 werden durch eine Steuereinheit 7 aufgezeichnet und in der Posttlight Simulation mit anderen Test-Daten verglichen und validiert. Zum Aufzeichnen der Navigationsdaten des Avionik-Prüflings 3 ist dieser durch eine Datenleitung 10 mit der Steuereinheit 7 verbunden.

Zum Simulieren eines Fluges sind die Haltevorrichtung 4 über eine erste Steuerleitung 8 und das Schlittensystem 6 über eine zweite Steuerleitung 9 von der Steuereinheit 7 ansteuerbar. Insbesondere erfolgt die Ansteuerung über analoge Signale. Die Ansteuerung der Haltevorrichtung 4 und des Schlittensystems 6 basieren auf den Simulationsdaten 18, die aus den realen Messdaten 17 gewonnen wurden. Somit entspricht die Bewegung des Avionik-Prüflings 3 einer realitätsnahen Simulation eines Fluges des Flugkörpers.

Die Stationäre 6DoF Testbench 1 hat folgende Hauptaufgaben:
- Verifikation Bildverarbeitungs-Algorithmik
- Verfikation LOS-Estimation
- Tuning LOS-Synchronisation
- IMU-Suchkopf-Synchronisation
- LOS Performance & Problematik (Timing, Stabilität, ...)
- LOS Decoupling
- Boresight error Estimation und Performance

Das Testsystem 16, insbesondere das mobile Testgerät 2 und das stationäre Testgerät 1, erlauben die komplette Relativgeometrie und Begegnungsgeometrie in 6 Freiheitsgraden eines jeden beliebigen Flugkörpers in "Zeitlupe" gegenüber einem stehenden Zieles in der Realität zu erzeugen. Dies ist mit herkömmlichen Testsystemen für Flugkörper nicht möglich.

Außerdem kann die gesamte Avionik (IMU, Suchkopf, Gimbal, Navigation, Bildverarbeitung,...) schon vor den ersten Flugtests Open Loop sowie Closed Loop getestet und Funktionalitäten in der Realität validiert werden.

Die Erfindung stellt einen validierten Avionik-Sensor Baukasten dar: Es können im Vorfeld von zukünftigen Entwicklungsvorhaben verschiedene Suchkopf- IMU-NGC Konzepte unter realistischen Einsatzbedingungen und unabhängig von ihren zukünftigen Trägerflugkörper getestet und validiert werden.

Außerdem können Flugtests ergänzt werden und Probleme in den Algorithmen bzw. der Avionik-Sensor-Kombination können frühzeitig erkannt werden. Die Flugversuche können zur Datenaufzeichnung mehrfach wiederholt und zur Post-Flight Analyse nachgestellt werden.

Aufgrund der Verfügbarkeit von realistischen Daten kann sowohl die NGC-Algorithmik als auch die Bildverarbeitungs-Algorithmik besser entwickelt und optimiert werden, als dies im Stand der Technik möglich ist.

Schließlich bietet die Erfindung ein hohes Einsparungspotenzial, weil teure Flugversuche mit echten Flugkörpern reduziert werden können, sowie eine erhebliche technische Risikominimierung
Neben der vorstehenden schriftlichen Beschreibung der Erfindung wird zu deren ergänzender Offenbarung hiermit explizit auf die zeichnerische Darstellung der Erfindung in den Fig. 1 bis 4 Bezug genommen.

### Bezugszeichenliste

- 1: stationäres Testgerät
- 2: mobiles Testgerät
- 3: Avionik-Prüfling
- 4: Haltevorrichtung
- 5: Anzeigevorrichtung
- 6: Schlittensystem
- 7: Steuereinheit
- 8: erste Steuerleitung
- 9: zweite Steuerleitung
- 10: Datenleitung
- 11: Flugplattform
- 12: Trägervorrichtung
- 13: Steuermodul
- 14: Rotor
- 15: Energiemodul
- 16: Testsystem
- 17: Messdaten
- 18: Simulationsdaten
- 19: erstes GADT
- 20: zweites GADT
- 21: Referenz-Trajektorie
- 22: erste Testdaten
- 23: zweite Testdaten

- 100: Idee
- 101: Anforderungen
- 102: Modeldesign
- 103: NGC-Algorithmus-Entwurf
- 104: Simulation und Analyse
- 105: Validierungsprozess
- 106: Ergebnisüberprüfung
- 107: Validierung Softwarecode
- 108: Avionik-Entwurf
- 109: Avionik-Validierung
- 110: Verifikation des Gesamtsystems
- 111: Validierung des Gesamtsystems
- 112: Qualitätskontrolle
- 113: fertiges Produkt

## Patentansprüche

1. Testsystem (16) für einen Flugkörper, umfassend ein mobiles Testgerät (2) und ein stationäres Testgerät (1) für einen Flugkörper,
wobei das mobile Testgerät (2) aufweist:
eine Flugplattform (11),
eine an der Flugplattform (11) befestigte Trägervorrichtung (12) für einen Avionik-Prüfling (3) des Flugkörpers, wobei die Trägervorrichtung (12) ein Bewegen des Avionik-Prüflings (3) in drei rotatorischen Freiheitsgraden ermöglicht; und
ein Steuermodul (13), wobei mit dem Steuermodul (13) die Flugplattform (11) zum Abfliegen einer vorbestimmten Referenz-Trajektorie (21) ansteuerbar ist, die Trägervorrichtung (12) zum rotatorischen Ausrichten des Avionik-Prüflings (3)
ansteuerbar ist, und von dem Avionik-Prüfling (3) erzeugte Daten speicherbar sind;
und wobei das stationäre Testgerät (1) aufweist:
eine Haltevorrichtung (4) für einen Avionik-Prüfling (3) des Flugkörpers, wobei die Haltevorrichtung (4) ein Bewegen des Avionik-Prüflings (3) in drei rotatorischen Freiheitsgraden ermöglicht; und
eine Anzeigevorrichtung (5) zum Darstellen von Umfeldinformationen des Flugkörpers, wobei die Anzeigevorrichtung (5) innerhalb einer virtuellen Ebene durch ein translatorisches Schlittensystem (6) verschiebbar ist;
wobei die Anzeigevorrichtung (5) von dem Avionik-Prüfling (3) erfassbar ist, wenn der Avionik-Prüfling (3) auf der Haltevorrichtung (4) angeordnet ist;
wobei das stationäre Testgerät (1) eine Steuereinheit (7) aufweist, mit der eine Bewegung der Haltevorrichtung (4) und eine Verschiebung der Anzeigevorrichtung (5) steuerbar ist, um das Abfliegen einer vordefinierten Referenz-Trajektorie (21) zu simulieren, und mit der von dem Avionik-Prüfling (3) erzeugte Daten speicherbar sind; und
wobei das stationäre Testgerät (1) mit Simulationsdaten (18) betreibbar ist, die aus Messdaten (17) gewonnen sind, wobei die Messdaten (17) während des Betriebs des mobilen Testgeräts (2) erfasst sind.

2. Testsystem (16) nach Anspruch 1, **dadurch gekennzeichnet, dass** die Trägervorrichtung (12) eine Gimbalplattform umfasst.

3. Testsystem (16) nach einem der Ansprüche 1 oder 2, **dadurch gekennzeichnet, dass** die Flugplattform (11) ein Hubschrauber, bevorzugt mit zumindest zwei horizontal orientierten Rotoren (14), umfasst.

4. Testsystem (16) nach einem der Ansprüche 1 bis 3, **dadurch gekennzeichnet, dass** die Haltevorrichtung (4) des stationären Testgeräts (1) ein Drehtisch oder ein Roboter ist.

5. Testsystem (16) nach einem der Anprüche 1 bis 4, **dadurch gekennzeichnet, dass** die Simulationsdaten (18), die aus den während des Betriebs des mobilen Testgeräts (2) gewonnenen Messdaten (17) gewinnbar sind, IMU-Daten, GPS-Daten, CAS-Daten und Suchkopf-Daten umfassen, wobei IMU für Inertial Measurement Unit, GPS für Global Positioning System und CAS für Control Actuator System steht.

6. Verfahren zum Testen von Flugkörpern mit einem Testsystem (16) nach einem der vorhergehenden Ansprüche , umfassend die Schritte:
Festlegen einer Referenz-Trajektorie (21), die eine Relativgeometrie zwischen dem Flugkörper und einem Ziel, das der Flugkörper anfliegen soll, nachbildet;
Abfliegen der Referenz-Trajektorie (21) mit einem mobilen Testgerät (2) nach einem der Ansprüche 1 bis 5, wobei an dem mobilen Testgerät ein Avionik-Prüfling (3) des Flugkörpers angeordnet ist; und
Simulieren einer Bewegung des Flugkörpers anhand von Simulationsdaten (18) mit einem stationären Testgerät (1) nach einem der Ansprüche 1 bis 5,
wobei der Avionik-Prüfling (3) an dem stationären Testgerät (1) angeordnet ist, und wobei die Simulationsdaten (18) auf den während des Abfliegens der Referenz-Trajektorie (21) erhaltenen Messdaten (17) basiert.

7. Verfahren nach Anspruch 6, **dadurch gekennzeichnet, dass** der Avionik-Prüfling (3) an einer Gimbalplattform angebracht wird.

## Claims

1. Test system (16) for a missile, comprising a mobile test device (2) and a stationary test device (1) for a missile, wherein the mobile test device (2) has:
a flight platform (11),
a carrier device (12), fixed to the flight platform (11), for an avionics specimen (3) of the missile, the carrier device (12) enabling movement of the avionics specimen (3) in three rotational degrees of freedom; and
a control module (13), the flight platform (11) being actuable for taking off on a predetermined reference trajectory (21), the carrier device (12) being actuable for rotational orientation of the avionics specimen (3), and data generated by the avionics specimen (3) being storable, by means of the control module (13);
and wherein the stationary test device (1) comprises:
a holding device (4) for an avionics specimen (3) of the missile, the holding device (4) enabling movement of the avionics specimen (3) in three rotational degrees of freedom; and
a display device (5) for representing environmental information of the missile, the display device (5) being displaceable within a virtual plane by a translator slide system (6);
the display device (5) being detectable by the avionics specimen (3) when the avionics specimen (3) is arranged on the holding device (4);
wherein the stationary test device (1) has a control unit (7), by means of which a movement of the holding device (4) and a displacement of the display device (5) are controllable so as to simulate taking off on a predefined reference trajectory (21), and by means of which data generated by the avionics specimen (3) are storable; and
wherein the stationary test device (1) is operable using simulation data (18) obtained from measurement data (17), the measurement data (17) having been detected during the operation of the mobile test device (2).

2. Test system (16) according to claim 1, **characterised in that** the carrier device (12) comprises a gimbal platform.

3. Test system (16) according to either claim 1 or claim 2, **characterised in that** the flight platform (11) comprises a helicopter, preferably comprising at least two horizontally orientated rotors (14).

4. Test system (16) according to any of claims 1 to 3, **characterised in that** the holding device (4) of the stationary test device (1) is a turntable or a robot.

5. Test system (16) according to any of claims 1 to 4, **characterised in that** the simulation data (18) obtainable from the measurement data (17) obtained during operation of the mobile test device (2) comprise IMU data, GPS data, CAS data and seeker head data, where IMU stands for inertial measurement unit, GPS stands for global positioning system and CAS stands for control actuator system.

6. Method for testing missiles using a test system (16) according to any of the preceding claims, comprising the steps of:
establishing a reference trajectory (21) which imitates a relative geometry between the missile and a target which the missile is to approach;
taking off on the reference trajectory (21) using a mobile test device (2) according to any of claims 1 to 5, an avionics specimen (3) of the missile being arranged on the mobile test device; and
simulating a movement of the missile by way of simulation data (18) using a stationary test device (1) according to any of claims 1 to 5,
the avionics sample (3) being arranged on the stationary test device (1) and the simulation data (18) being based on the measurement data (17) obtained during taking off on the reference trajectory (21).

7. Method according to claim 6, **characterised in that** the avionics specimen (3) is attached to a gimbal platform.

## Revendications

1. Système d'essai (16) pour un missile, comprenant un dispositif d'essai mobile (2) et un dispositif d'essai fixe (1) pour un missile,
le dispositif d'essai mobile (2) présentant :
une plate-forme de vol (11),
un dispositif de support (12) fixé à la plate-forme de vol (11) pour un objet d'essai avionique (3) du missile, le dispositif de support (12) permettant de déplacer l'objet d'essai avionique (3) selon trois degrés de liberté de rotation ; et
un module de commande (13), le module de commande (13) pouvant être utilisé pour commander la plate-forme de vol (11) afin de suivre une trajectoire de référence prédéterminée (21), pour commander le dispositif de support (12) afin d'orienter en rotation l'objet d'essai avionique (3) et pour stocker des données générées par l'objet d'essai avionique (3) ;
et le dispositif d'essai fixe (1) présentant :
un dispositif de maintien (4) pour un objet d'essai avionique (3) du missile, le dispositif de maintien (4) permettant de déplacer l'objet d'essai avionique (3) selon trois degrés de liberté de rotation ; et
un dispositif d'affichage (5) pour représenter des informations sur l'environnement du missile, le dispositif d'affichage (5) étant déplaçable dans un plan virtuel par un système de chariot en translation (6) ;
le dispositif d'affichage (5) étant détectable par l'objet d'essai avionique (3) lorsque l'objet d'essai avionique (3) est disposé sur le dispositif de maintien (4) ;
le dispositif d'essai fixe (1) présentant une unité de commande (7) avec laquelle un mouvement du dispositif de maintien (4) et un déplacement du dispositif d'affichage (5) peuvent être commandés afin de simuler le suivi d'une trajectoire de référence prédéfinie (21), et avec laquelle des données générées par l'objet d'essai avionique (3) peuvent être stockées ; et
le dispositif d'essai fixe (1) pouvant être utilisé avec des données de simulation (18) obtenues à partir de données de mesure (17), les données de mesure (17) étant acquises pendant le fonctionnement du dispositif d'essai mobile (2).

2. Système d'essai (16) selon la revendication 1, **caractérisé en ce que** le dispositif de support (12) comprend une plate-forme à cardan.

3. Système d'essai (16) selon l'une des revendications 1 ou 2, **caractérisé en ce que** la plate-forme de vol (11) comprend un hélicoptère, de préférence avec au moins deux rotors (14) orientés horizontalement.

4. Système d'essai (16) selon l'une des revendications 1 à 3, **caractérisé en ce que** le dispositif de maintien (4) du dispositif d'essai fixe (1) est un plateau tournant ou un robot.

5. Système d'essai (16) selon l'une des revendications 1 à 4, **caractérisé en ce que** les données de simulation (18) qui peuvent être obtenues à partir des données de mesure (17) obtenues pendant le fonctionnement du dispositif d'essai mobile (2) comprennent des données IMU, des données GPS, des données CAS et des données de tête chercheuse, IMU étant l'abréviation d'Inertial Measurement Unit, GPS de Global Positioning System et CAS de Control Actuator System.

6. Procédé d'essai de missiles avec un système d'essai (16) selon l'une des revendications précédentes, comprenant les étapes consistant à :
définir une trajectoire de référence (21) qui reproduit une géométrie relative entre le missile et une cible vers laquelle le missile doit voler ;
suivre la trajectoire de référence (21) avec un dispositif d'essai mobile (2) selon l'une des revendications 1 à 5, un objet d'essai avionique (3) du missile étant disposé sur le dispositif d'essai mobile ; et
simuler un mouvement du missile sur la base de données de simulation (18) avec un dispositif d'essai fixe (1) selon l'une des revendications 1 à 5,
l'objet d'essai avionique (3) étant disposé sur le dispositif d'essai fixe (1) et les données de simulation (18) étant basées sur les données de mesure (17) obtenues pendant le suivi de la trajectoire de référence (21).

7. Procédé selon la revendication 6, **caractérisé en ce que** l'objet d'essai avionique (3) est monté sur une plate-forme à cardan.
